# EUROPÄISCHE PATENTSCHRIFT

(11) **EP 3 679 303 B1**
(45) Veröffentlichungstag und Bekanntmachung des Hinweises auf die Patenterteilung: **11.10.2023**
(21) Anmeldenummer: 18772897.7
(22) Anmeldetag: 24.08.2018
(51) Int. Cl.: F24C 15/10, F24C 7/08, H05B 6/12

(54) **KOCHFELDVORRICHTUNG**
HOB APPARATUS
DISPOSITIF DE PLAQUE DE CUISSON

(30) Priorität: 07.09.2017 ES 201731086
(43) Veröffentlichungstag der Anmeldung: 15.07.2020
(73) Patentinhaber: BSH Hausgeräte GmbH, 81739 München (DE)
(72) Erfinder: ARENAS JIMENEZ, Beatriz, 50196 La Muela (ES); ARNAL VALERO, Adolfo, 50009 Zaragoza (ES); AZUARA GAZO, Jesus Enrique, 50021 Zaragoza (ES); LAPETRA CAMPOS, Isaac, 50003 Zaragoza (ES); ORTIZ SAINZ, David, 50298 Pinseque (Zaragoza) (ES); PINA GADEA, Carmelo, 50008 Zaragoza (ES)
(86) Internationale Anmeldenummer: PCT/IB2018/056440
(87) Internationale Veröffentlichungsnummer: WO 2019/048977

(56) Entgegenhaltungen:
- EP-A1- 2 703 724
- WO-A1-2014/016033
- WO-A1-2015/149824
- CN-U- 201 463 007
- GB-A- 2 100 853

## Beschreibung

Die Erfindung betrifft eine Kochfeldvorrichtung nach dem Oberbegriff des Anspruchs 1 und ein Verfahren zu einer Montage einer Kochfeldvorrichtung nach dem Oberbegriff des Anspruchs 8.

Aus dem Stand der Technik ist bereits eine Kochfeldvorrichtung bekannt, welche eine Kochfeldplatte und eine Elektronikeinheit aufweist. Die Elektronikeinheit ist in einer Einbaulage unterhalb der Kochfeldplatte angeordnet. Eine Lagereinheit lagert die Elektronikeinheit in einer Lage, in welcher eine Haupterstreckungsebene der Elektronikeinheit parallel zu einer Haupterstreckungsebene der Kochfeldplatte ausgerichtet ist. Weiterer Stand der Technik ist den Dokumenten WO 2014/016033 A1 und GB 2 100 853 A zu entnehmen.

Die Aufgabe der Erfindung besteht insbesondere darin, eine gattungsgemäße Vorrichtung mit verbesserten Eigenschaften hinsichtlich einer Konstruktion bereitzustellen. Die Aufgabe wird erfindungsgemäß durch die Merkmale der Ansprüche 1 und 8 gelöst, während vorteilhafte Ausgestaltungen und Weiterbildungen der Erfindung den Unteransprüchen entnommen werden können.

Die Erfindung geht aus von einer Kochfeldvorrichtung, insbesondere von einer Induktionskochfeldvorrichtung, mit zumindest einer Kochfeldplatte, mit zumindest einer Elektronikeinheit und mit zumindest einer Lagereinheit, welche die Elektronikeinheit in wenigstens einem montierten Zustand relativ zu der Kochfeldplatte lagert.

Es wird vorgeschlagen, dass die Lagereinheit die Elektronikeinheit in einer Lage relativ zu der Kochfeldplatte lagert, in welcher eine Haupterstreckungsebene der Elektronikeinheit winklig zu einer Haupterstreckungsebene der Kochfeldplatte ausgerichtet ist. Durch eine derartige Ausgestaltung kann insbesondere eine besonders vorteilhafte und platzsparende Konstruktion erreicht werden. Insbesondere kann hierdurch ein freier bislang ungenutzter Raum zu einer Lagerung der Elektronikeinheit verwendet werden, wodurch insbesondere neuartige Elektronikeinheiten integriert werden können, und zwar insbesondere unter Vermeidung einer Vergrößerung eines Kochfeldaußengehäuses. Insbesondere kann aufgrund einer winkligen und besonders vorteilhaft aufgrund einer senkrechten Lage der Elektronikeinheit eine einfache und/oder problemlose Kontaktierung der Elektronikeinheit ermöglicht werden. Die Elektronikeinheit kann insbesondere auf einfache und/oder schnelle Weise montiert werden, wodurch insbesondere geringe Kosten, insbesondere bei einer Montage, erzielt werden können.

Unter einer "Kochfeldvorrichtung", insbesondere unter einer "Induktionskochfeldvorrichtung", soll insbesondere zumindest ein Teil, insbesondere eine Unterbaugruppe, eines Kochfelds, insbesondere eines Induktionskochfelds, verstanden werden.

Unter einer "Kochfeldplatte" soll insbesondere eine Einheit verstanden werden, die in wenigstens einem Betriebszustand zu einem Aufstellen von Gargeschirr vorgesehen ist und die insbesondere dazu vorgesehen ist, einen Teil eines Kochfeldaußengehäuses, insbesondere der Kochfeldvorrichtung und/oder eines die Kochfeldvorrichtung aufweisenden Kochfelds, auszubilden. Insbesondere bildet die Kochfeldplatte in einer Einbaulage einen einem Bediener zugewandten Teil des Kochfeldaußengehäuses aus. Die Kochfeldplatte besteht insbesondere wenigstens zu einem Großteil aus Glas und/oder Glaskeramik. Unter "wenigstens zu einem Großteil" soll insbesondere zu einem Anteil von mindestens 70 %, insbesondere zu mindestens 80 %, vorteilhaft zu mindestens 90 % und vorzugsweise zu mindestens 95 % verstanden werden.

Unter einer "Elektronikeinheit" soll insbesondere eine elektrische und/oder elektronische Einheit verstanden werden, welche zumindest eine elektrische und/oder elektronische Baueinheit aufweist. Insbesondere weist die Elektronikeinheit zumindest eine Leiterplatte und insbesondere zusätzlich die elektrische und/oder elektronische Baueinheit auf, die insbesondere wenigstens in einem montierten Zustand an der Leiterplatte angeordnet ist. Die Baueinheit könnte beispielsweise zumindest einen Wechselrichter und/oder zumindest eine Steuereinheit und/oder zumindest eine Kühlungseinheit sein. Die Baueinheit könnte insbesondere zu einer Verarbeitung und/oder zu einer Weiterleitung und/oder zu einem Empfang und/oder zu einem Senden und/oder zu einer Detektion von elektrischen und/oder elektronischen Daten vorgesehen sein. Die Baueinheit könnte beispielsweise ein Sensor sein. Alternativ oder zusätzlich könnte die Baueinheit zumindest eine Empfangseinheit sein, welche insbesondere zu einem drahtlosen Empfang von Daten vorgesehen sein könnte. Insbesondere könnte die Baueinheit alternativ oder zusätzlich eine Steuereinheit und/oder eine Recheneinheit aufweisen, welche insbesondere zu einer Verarbeitung von Daten vorgesehen sein könnte. Insbesondere könnte die Baueinheit eine Recheneinheit und insbesondere zusätzlich zur Recheneinheit eine Speichereinheit mit einem darin gespeicherten Steuer- und/oder Regelprogramm aufweisen, das insbesondere dazu vorgesehen sein könnte, von der Recheneinheit ausgeführt zu werden. Die Baueinheit könnte alternativ oder zusätzlich insbesondere zumindest eine Filtereinheit sein. Insbesondere könnte die Baueinheit zumindest zu einer Versorgung des Heizelements, insbesondere mit elektrischer Energie, vorgesehen sein und insbesondere als ein Leistungsbauelement ausgebildet sein.

Unter einer "Lagereinheit" soll insbesondere eine Einheit verstanden werden, welche in dem montierten Zustand eine Lage der Elektronikeinheit relativ zu zumindest einer weiteren Baueinheit, welche insbesondere die Kochfeldplatte selbst und/oder zumindest eine mit der Kochfeldplatte wenigstens im Wesentlichen starr verbundene Baueinheit sein könnte, wenigstens im Wesentlichen und insbesondere unter Berücksichtigung von Toleranzen vollständig festlegt und welche insbesondere in dem montierten Zustand eine Gewichtskraft der Elektronikeinheit wenigstens zu einem Großteil aufnimmt und/oder an zumindest eine weitere Baueinheit weiterleitet. Insbesondere legt die Lagereinheit aufgrund einer wenigstens im Wesentlichen starren Verbindung zwischen der Kochfeldplatte und zumindest einer weiteren Baueinheit, und/oder insbesondere zwischen der Kochfeldplatte und zumindest zwei weiteren Baueinheiten, eine Lage der Elektronikeinheit relativ zu der Kochfeldplatte wenigstens im Wesentlichen und insbesondere unter Berücksichtigung von Toleranzen vollständig fest. Die weitere Baueinheit könnte beispielsweise die Kochfeldplatte sein, an welcher die Lagereinheit angeordnet und/oder befestigt sein könnte. Insbesondere ist die weitere Baueinheit von der Kochfeldplatte getrennt ausgebildet und vorteilhaft mittelbar und/oder unmittelbar wenigstens im Wesentlichen starr mit der Kochfeldplatte verbunden. Beispielsweise könnte die weitere Baueinheit zumindest ein Raumteilerelement und/oder zumindest eine Außengehäuseeinheit sein. Unter einer "Lage" eines Objekts relativ zu der Kochfeldplatte soll insbesondere eine Anordnung und/oder eine Ausrichtung des Objekts relativ zu der Kochfeldplatte verstanden werden. Insbesondere legt die Lageeinheit in dem montierten Zustand einen Winkel der Haupterstreckungsebene der Elektronikeinheit relativ zu der Haupterstreckungsebene der Kochfeldplatte wenigstens im Wesentlichen und insbesondere unter Berücksichtigung von Toleranzen vollständig fest. Die Lagereinheit legt in dem montierten Zustand insbesondere eine Position der Elektronikeinheit relativ zu der Kochfeldplatte und/oder einen Abstand der Elektronikeinheit von der Kochfeldplatte wenigstens im Wesentlichen und insbesondere unter Berücksichtigung von Toleranzen vollständig fest.

Unter einer "Haupterstreckungsebene" eines Objekts soll insbesondere eine Ebene verstanden werden, welche parallel zu einer größten Seitenfläche eines kleinsten gedachten geometrischen Quaders ist, welcher das Objekt gerade noch vollständig umschließt, und insbesondere durch den Mittelpunkt des Quaders verläuft. Beispielsweise könnte die Lagereinheit wenigstens zu einem Großteil aus Metall bestehen. Vorteilhaft könnte die Lagereinheit wenigstens zu einem Großteil aus Kunststoff bestehen. Die Lagereinheit, welche insbesondere wenigstens zu einem Großteil aus Kunststoff bestehen könnte, könnte insbesondere zu einer Abschirmung der Elektronikeinheit und/oder Entkopplung der Elektronikeinheit vorgesehen sein.

Unter der Wendung, dass die Lagereinheit die Elektronikeinheit in einer Lage relativ zu der Kochfeldplatte lagert, in welcher eine Haupterstreckungsebene der Elektronikeinheit "winklig" zu einer Haupterstreckungsebene der Kochfeldplatte ausgerichtet ist, ist zu verstehen, dass die Lagereinheit die Elektronikeinheit in einer Lage relativ zu der Kochfeldplatte lagert, in welcher die Haupterstreckungsebene der Elektronikeinheit und die Haupterstreckungsebene der Kochfeldplatte einen minimalen Winkel von mehr als 0° und weniger als 180° miteinander einschließen und von einer parallelen Anordnung relativ zueinander verschieden angeordnet sind. In dem montierten Zustand schließt die Haupterstreckungsebene der Elektronikeinheit mit der Haupterstreckungsebene der Kochfeldplatte insbesondere einen minimalen Winkel in einem Bereich von insbesondere exklusive 0° bis insbesondere inklusive 90° ein. Insbesondere schließt die Haupterstreckungsebene der Elektronikeinheit mit der Haupterstreckungsebene der Kochfeldplatte insbesondere in dem montierten Zustand einen minimalen Winkel von mindestens 1°, insbesondere von mindestens 5°, vorteilhaft von mindestens 10°, besonders vorteilhaft von mindestens 15° und vorzugsweise von mindestens 20° ein. Insbesondere beträgt ein minimaler Winkel zwischen der Haupterstreckungsebene der Elektronikeinheit und der Haupterstreckungsebene der Kochfeldplatte maximal 90°, da insbesondere ein Winkel von mehr als 90° von einem minimalen Winkel verschieden ist. Insbesondere weisen die Haupterstreckungsebene der Elektronikeinheit und die Haupterstreckungsebene der Kochfeldplatte in dem montierten Zustand, insbesondere bei einer unendlichen Ausdehnung der Haupterstreckungsebenen, zumindest einen gemeinsamen Schnittpunkt und insbesondere zumindest eine gemeinsame Schnittgerade auf.

Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Die Lagereinheit könnte die Elektronikeinheit in dem montierten Zustand insbesondere in einer Lage relativ zu der Kochfeldplatte lagern, in welcher die Haupterstreckungsebene der Elektronikeinheit einen Winkel von maximal 85°, insbesondere von maximal 80°, vorteilhaft von maximal 75° und vorzugsweise von maximal 70° zu der Haupterstreckungsebene der Kochfeldplatte aufweisen könnte. Vorzugsweise lagert die Lagereinheit die Elektronikeinheit in dem montierten Zustand in einer Lage relativ zu der Kochfeldplatte, in welcher die Haupterstreckungsebene der Elektronikeinheit wenigstens im Wesentlichen senkrecht und insbesondere unter Berücksichtigung von Toleranzen vollständig senkrecht zu der Haupterstreckungsebene der Kochfeldplatte ausgerichtet ist. Der Ausdruck "im Wesentlichen senkrecht" soll hier insbesondere eine Ausrichtung einer Richtung relativ zu einer Bezugsrichtung definieren, wobei die Richtung und die Bezugsrichtung, insbesondere in einer Ebene betrachtet, einen Winkel von 90° einschließen und der Winkel eine maximale Abweichung von insbesondere kleiner als 8°, vorteilhaft kleiner als 5° und besonders vorteilhaft kleiner als 2° aufweist. Dadurch kann die Elektronikeinheit insbesondere in bislang ungenutztem Raum gelagert werden, in welchem die Elektronikeinheit insbesondere aufgrund der wenigstens im Wesentlichen senkrechten Lage der Elektronikeinheit relativ zu der Kochfeldplatte gelagert werden kann.

Zudem wird vorgeschlagen, dass die Lagereinheit die Elektronikeinheit in dem montierten Zustand in zumindest einer Ebene betrachtet bezüglich eines Mittelpunkts und/oder Schwerpunkts der Elektronikeinheit über einen Winkelbereich von mindestens 180°, insbesondere von mindestens 270°, vorteilhaft von mindestens 300° und vorzugsweise von mindestens 330° umgibt. Die Ebene, in welcher die Lagereinheit die Elektronikeinheit in dem montierten Zustand insbesondere bezüglich eines Mittelpunkts und/oder Schwerpunkts der Elektronikeinheit über den Winkelbereich umgibt, könnte in dem montierten Zustand beispielsweise winklig und/oder senkrecht zu der Haupterstreckungsebene der Kochfeldplatte ausgerichtet sein. Vorteilhaft ist die Ebene, in welcher die Lagereinheit die Elektronikeinheit in dem montierten Zustand insbesondere bezüglich eines Mittelpunkts und/oder Schwerpunkts der Elektronikeinheit über den Winkelbereich umgibt, in dem montierten Zustand wenigstens im Wesentlichen parallel zu der Haupterstreckungsebene der Kochfeldplatte ausgerichtet. Unter "im Wesentlichen parallel" soll hier insbesondere eine Ausrichtung einer Richtung relativ zu einer Bezugsrichtung, insbesondere in einer Ebene, verstanden werden, wobei die Richtung gegenüber der Bezugsrichtung eine Abweichung insbesondere kleiner als 8°, vorteilhaft kleiner als 5° und besonders vorteilhaft kleiner als 2° aufweist. Dadurch kann insbesondere eine sichere und/oder geschützte Lagerung der Elektronikeinheit erzielt werden, wodurch insbesondere eine langlebige Ausgestaltung und/oder eine hohe Funktionstüchtigkeit ermöglicht werden kann.

Die Kochfeldvorrichtung umfasst zumindest ein Raumteilerelement, welches die Lagereinheit in dem montierten Zustand wenigstens zu einem Großteil trägt. Unter einem "Raumteilerelement" soll insbesondere ein Element verstanden werden, das dazu vorgesehen ist, in dem montierten Zustand zumindest einen Lagerraum in zumindest zwei Teilräume zu unterteilen. Insbesondere weist das Raumteilerelement eine wenigstens im Wesentlichen plattenartige Gestalt auf und ist insbesondere als eine Platte ausgebildet. Vorzugsweise ist das Raumteilerelement in dem montierten Zustand zwischen zumindest einem Heizelement und zumindest einer weiteren Elektronikeinheit, wie beispielsweise einer Steuereinheit und/oder zumindest einer Lichtquelle und/oder zumindest einer Kochfeldelektronik und/oder zumindest einer Leistungselektronik, angeordnet. Vorteilhaft ist das Raumteilerelement dazu vorgesehen, den Lagerraum großräumig zu unterteilen. Das Raumteilerelement weist insbesondere eine Flächenerstreckung von mindestens 0,1 m², insbesondere von mindestens 0,2 m², vorteilhaft von mindestens 0,3 m², besonders vorteilhaft von mindestens 0,35 m² und vorzugsweise von mindestens 0,4 m² auf. Insbesondere weist das Raumteilerelement eine Längserstreckung von mindestens 30 cm, insbesondere von mindestens 40 cm, vorteilhaft von mindestens 50 cm, besonders vorteilhaft von mindestens 60 cm und vorzugsweise von mindestens 80 cm auf. Das Raumteilerelement weist insbesondere eine Quererstreckung von mindestens 30 cm, insbesondere von mindestens 40 cm, vorteilhaft von mindestens 50 cm, besonders vorteilhaft von mindestens 55 cm und vorzugsweise von mindestens 60 cm auf. Unter einer "Längserstreckung" eines Objekts soll insbesondere eine Länge einer längsten Seite eines kleinsten gedachten geometrischen Quaders verstanden werden, welcher das Objekt gerade noch vollständig umschließt. Unter einer "Quererstreckung" eines Objekts soll insbesondere Erstreckung des Objekts verstanden werden, welche senkrecht zu einer Längserstreckung des Objekts ausgerichtet ist. Das Raumteilerelement nimmt in dem montierten Zustand insbesondere eine Gewichtskraft der Elektronikeinheit wenigstens zu einem Großteil auf und leitet diese Gewichtskraft insbesondere an zumindest ein weiteres Objekt, wie beispielsweise an zumindest eine Außengehäuseeinheit und/oder an die Kochfeldplatte, weiter. Das weitere Objekt ist insbesondere Teil der Kochfeldvorrichtung. Dadurch kann insbesondere eine bereits vorhandene Baueinheit zu einer Anordnung der Lagereinheit verwendet werden, wodurch insbesondere auf weitere und/oder zusätzliche Baueinheiten verzichtet und/oder geringe Kosten ermöglicht werden können/kann.

In dem montierten Zustand ist die Lagereinheit an dem Raumteilerelement angeordnet. Beispielsweise könnte die Lagereinheit in einer Einbaulage auf einer Oberfläche des Raumteilerelements angeordnet und/oder an einer Unterseite des Raumteilerelements angebracht sein. Die Lagereinheit greift in dem montierten Zustand wenigstens teilweise durch eine Lagerausnehmung des Raumteilerelements hindurch.

Das Raumteilerelement weist die Lagerausnehmung auf, welche insbesondere ein Loch und/oder eine Öffnung und/oder eine Aussparung in dem Raumteilerelement ist. Unter der Wendung, dass die Lagereinheit in dem montierten Zustand wenigstens "teilweise" durch eine Lagerausnehmung des Raumteilerelements hindurchgreift, soll insbesondere verstanden werden, dass die Lagereinheit zumindest einen Teilbereich aufweist, welcher in dem montierten Zustand durch die Lagerausnehmung des Raumteilerelements hindurchgreift. Dadurch kann insbesondere eine besonders vorteilhafte Konstruktion erreicht werden. Die Lagereinheit könnte in dem montierten Zustand beispielsweise an der Lagerausnehmung des Raumteilerelements verrastet sein. Vorzugsweise ist die Lagereinheit in dem montierten Zustand in die Lagerausnehmung des Raumteilerelements eingehängt. Insbesondere weist die Lagereinheit zumindest einen Teilbereich mit einer Erstreckung auf, welche größer ist als eine Erstreckung der Lagerausnehmung in dem montierten Zustand in einer der Erstreckung des Teilbereichs entsprechenden Richtung. Die Lagereinheit liegt insbesondere in dem montierten Zustand und in einer Einbaulage mit dem Teilbereich auf einer Oberfläche des Raumteilerelements auf. Insbesondere ragt die Lagereinheit mit zumindest einem weiteren Teilbereich durch die Lagerausnehmung des Raumteilerelements hindurch. Insbesondere sind der Teilbereich und der weitere Teilbereich in dem montierten Zustand auf einander gegenüberliegenden Seiten des Raumteilerelements angeordnet. Dadurch kann insbesondere eine einfache und/oder schnelle Montage ermöglicht werden, wodurch insbesondere eine geringe Montagezeit und/oder geringe Montagekosten erzielt werden können/kann. Insbesondere kann eine Montage der Elektronikeinheit und/oder der Lagereinheit in insbesondere ausschließlich einer einzigen Montagerichtung erfolgen, wodurch insbesondere eine ganz schnelle und/oder einfache und/oder kostengünstige Montage erzielt werden kann. Weiterhin wird vorgeschlagen, dass die Lagereinheit in dem montierten Zustand und in einer Einbaulage wenigstens zu einem Großteil unterhalb des Raumteilerelements angeordnet ist. Dadurch kann die Elektronikeinheit insbesondere geschützt gelagert werden, und zwar insbesondere in einem Bereich geringer Temperatur. Insbesondere kann die Elektronikeinheit durch das Raumteilerelement von einem in einer Einbaulage oberhalb des Raumteilerelements angeordneten Heizelement abgeschirmt werden, wodurch insbesondere eine hohe Funktionstüchtigkeit der Elektronikeinheit und/oder eine langlebige Ausgestaltung erzielt werden kann.

Die Elektronikeinheit ist in dem montierten Zustand und in einer Einbaulage wenigstens teilweise oberhalb des Raumteilerelements und insbesondere wenigstens zu einem Großteil unterhalb des Raumteilerelements angeordnet. Unter der Wendung, dass die die Elektronikeinheit in dem montierten Zustand und in einer Einbaulage wenigstens "teilweise" oberhalb des Raumteilerelements angeordnet ist, soll insbesondere verstanden werden, dass die Elektronikeinheit zumindest einen Teilbereich aufweist, welcher in dem montierten Zustand und in einer Einbaulage oberhalb des Raumteilerelements angeordnet ist, wobei die Elektronikeinheit insbesondere zumindest einen weiteren Teilbereich aufweisen könnte, welcher unterhalb des Raumteilerelements angeordnet sein könnte. Die Elektronikeinheit könnte beispielsweise zumindest eine elektrische und/oder elektronische Baueinheit aufweisen, welche insbesondere in dem montierten Zustand und in einer Einbaulage oberhalb des Raumteilerelements angeordnet sein könnte und welche insbesondere zu einem Senden und/oder zu einem Empfangen von Daten vorgesehen sein könnte. Vorteilhaft ist die Elektronikeinheit in dem montierten Zustand und in einer Einbaulage wenigstens zu einem Großteil unterhalb des Raumteilerelements angeordnet, wodurch der Großteil der Elektronikeinheit insbesondere gegenüber Wärmestrahlung abgeschirmt werden kann. Insbesondere ist das Raumteilerelement dazu vorgesehen, die Elektronikeinheit in wenigstens einem Betriebszustand wenigstens teilweise abzuschirmen, und zwar insbesondere zumindest gegenüber Wärmestrahlung. Dadurch kann insbesondere eine vollständige Abschirmung der Elektronikeinheit, welche in dem montierten Zustand und in einer Einbaulage insbesondere durch eine vollständige Anordnung der Elektronikeinheit unterhalb des Raumteilerelements hergestellt wäre, vermieden werden, wodurch insbesondere eine Übertragung von Daten an die Elektronikeinheit ermöglicht werden kann.

Weiterhin wird vorgeschlagen, dass die Elektronikeinheit von einer Leistungselektronik, welche insbesondere zu einer Versorgung zumindest eines Heizelements vorgesehen ist, verschieden ist. Dadurch können insbesondere Probleme, welche in Zusammenhang mit einer Kühlung einer in einer Einbaulage winklig ausgerichteten Leistungselektronik entstehen könnten, bereits im Vorfeld vermieden werden, wodurch insbesondere eine hohe Funktionstüchtigkeit gewährleistet werden kann.

Eine besonders optimierte Konstruktion kann insbesondere erreicht werden durch ein Kochfeld, insbesondere durch ein Induktionskochfeld, mit zumindest einer Kochfeldvorrichtung. Eine Konstruktion kann insbesondere wesentlich verbessert werden durch ein Verfahren zu einer Montage einer Kochfeldvorrichtung, mit zumindest einer Kochfeldplatte und mit zumindest einer Elektronikeinheit, welche in wenigstens einem montierten Zustand relativ zu der Kochfeldplatte gelagert wird, wobei die Elektronikeinheit in einer Lage relativ zu der Kochfeldplatte gelagert wird, in welcher eine Haupterstreckungsebene der Elektronikeinheit winklig zu einer Haupterstreckungsebene der Kochfeldplatte ausgerichtet ist.

Die Kochfeldvorrichtung soll hierbei nicht auf die oben beschriebene Anwendung und Ausführungsform beschränkt sein. Insbesondere kann die Kochfeldvorrichtung zu einer Erfüllung einer hierin beschriebenen Funktionsweise eine von einer hierin genannten Anzahl von einzelnen Elementen, Bauteilen und Einheiten abweichende Anzahl aufweisen.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination.

Es zeigen:
- Fig. 1: ein Kochfeld mit einer Kochfeldvorrichtung in einer schematischen Draufsicht,
- Fig. 2: einen Ausschnitt einer Außengehäuseeinheit, einer Kochfeldplatte und eines Raumteilerelements der Kochfeldvorrichtung sowie eine Lagereinheit und eine Elektronikeinheit der Kochfeldvorrichtung in einem montierten Zustand in einer schematischen Schnittdarstellung,
- Fig. 3: einen Ausschnitt des Raumteilerelements sowie die Lagereinheit und die Elektronikeinheit in dem montierten Zustand in einer schematischen perspektivischen Darstellung,
- Fig. 4: einen Ausschnitt des Raumteilerelements sowie die Lagereinheit und die Elektronikeinheit in einem ersten Verfahrensschritt in einer schematischen perspektivischen Darstellung,
- Fig. 5: einen Ausschnitt des Raumteilerelements sowie die Lagereinheit und die Elektronikeinheit in einem zweiten Verfahrensschritt in einer schematischen perspektivischen Darstellung,
- Fig. 6: einen Ausschnitt des Raumteilerelements sowie die Lagereinheit und die Elektronikeinheit in einem dritten Verfahrensschritt in einer schematischen perspektivischen Darstellung,
- Fig. 7 erfindungsgemäßen: einen Ausschnitt einer Außengehäuseeinheit einer nicht Kochfeldvorrichtung sowie eine Lagereinheit und eine Elektronikeinheit der Kochfeldvorrichtung in einem montierten Zustand in einer schematischen Darstellung,
- Fig. 8: einen Ausschnitt der Außengehäuseeinheit und die Lagereinheit mit Blick auf eine Innenseite der Außengehäuseeinheit in einer vergrößerten schematischen Darstellung und
- Fig. 9: einen Ausschnitt der Außengehäuseeinheit und die Lagereinheit mit Blick auf eine Außenseite der Außengehäuseeinheit in einer vergrößerten schematischen Darstellung.

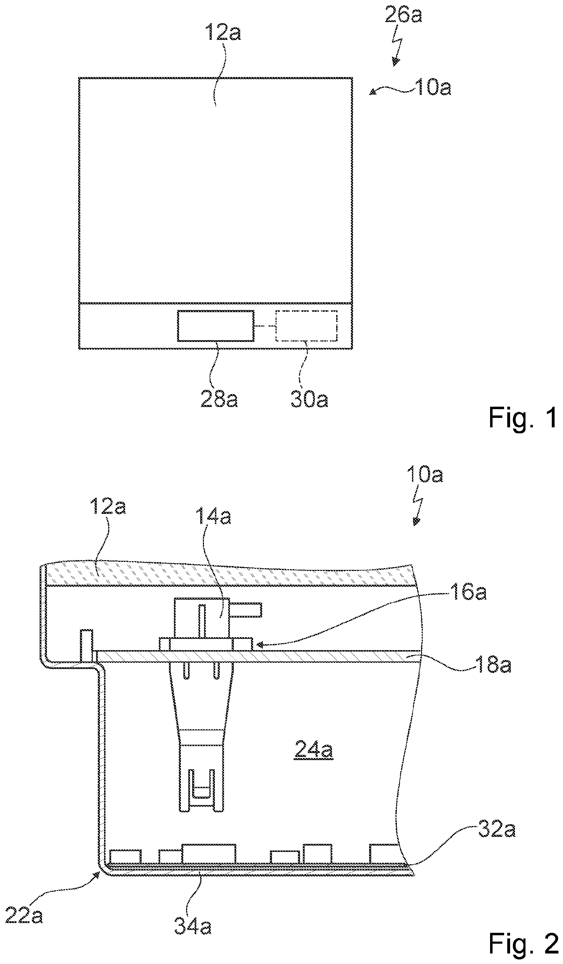

Fig. 1 zeigt ein Kochfeld 26a, das als ein Induktionskochfeld ausgebildet ist, mit einer Kochfeldvorrichtung 10a, die als eine Induktionskochfeldvorrichtung ausgebildet ist.

Die Kochfeldvorrichtung 10a weist eine Kochfeldplatte 12a auf. In einem montierten Zustand bildet die Kochfeldplatte 12a einen Teil eines Kochfeldaußengehäuses aus, und zwar insbesondere eines Kochfeldaußengehäuses insbesondere des Kochfelds 26a. Die Kochfeldplatte 12a ist zu einem Aufstellen von Gargeschirr vorgesehen (nicht dargestellt).

Die Kochfeldvorrichtung 10a weist zumindest ein Heizelement auf (nicht dargestellt). Im vorliegenden Ausführungsbeispiel weist die Kochfeldvorrichtung 10a mehrere Heizelemente auf. Im Folgenden wird jedoch lediglich eines der Heizelemente beschrieben. Das Heizelement ist in einer Einbaulage unterhalb der Kochfeldplatte 12a angeordnet. Das Heizelement ist dazu vorgesehen, auf der Kochfeldplatte 12a oberhalb des Heizelements aufgestelltes Gargeschirr zu erhitzen. Das Heizelement ist als Induktionsheizelement ausgebildet.

Die Kochfeldvorrichtung 10a weist eine Bedienerschnittstelle 28a zu einer Eingabe und/oder Auswahl von Betriebsparametern auf, beispielsweise einer Heizleistung und/oder einer Heizleistungsdichte und/oder einer Heizzone. Die Bedienerschnittstelle 28a ist zu einer Ausgabe eines Werts eines Betriebsparameters an einen Bediener vorgesehen.

Die Kochfeldvorrichtung 10a weist eine Steuereinheit 30a auf. Die Steuereinheit 30a ist dazu vorgesehen, in Abhängigkeit von mittels der Bedienerschnittstelle 28a eingegebener Betriebsparameter Aktionen auszuführen und/oder Einstellungen zu verändern. Die Steuereinheit 30a regelt in einem Heizbetriebszustand eine Energiezufuhr zu dem Heizelement.

Die Kochfeldvorrichtung 10a weist eine Außengehäuseeinheit 22a auf (vgl. Fig. 2). Die Außengehäuseeinheit 22a bildet einen Teil des Kochfeldaußengehäuses aus. In dem montierten Zustand sind die Außengehäuseeinheit 22a und die Kochfeldplatte 12a miteinander verbunden, insbesondere aneinander befestigt. Die Außengehäuseeinheit 22a und die Kochfeldplatte 12a definieren einen Lagerraum 24a.

Die Kochfeldvorrichtung 10a weist ein Raumteilerelement 18a auf (vgl. Fig. 2 bis 6). In dem montierten Zustand ist das Raumteilerelement 18a teilweise an der Außengehäuseeinheit 22a befestigt. In einer Einbaulage liegt das Raumteilerelement 18a teilweise auf der Außengehäuseeinheit 22a, insbesondere auf einer Ausformung der Außengehäuseeinheit 22a und/oder auf einer Stufe der Außengehäuseeinheit 22a, auf.

Das Raumteilerelement 18a unterteilt den Lagerraum 24a in zwei Teilräume. Ein erster Teilraum ist in einer Einbaulage oberhalb des Raumteilerelements 18a angeordnet. Der erste Teilraum ist in dem montierten Zustand auf einer der Kochfeldplatte 12a zugewandten Seite des Raumteilerelements 18a angeordnet. In dem ersten Teilraum ist das Heizelement angeordnet. Das Raumteilerelement 18a trägt in einer Einbaulage das Heizelement zu einem Großteil.

Ein zweiter Teilraum ist in einer Einbaulage unterhalb des Raumteilerelements 18a angeordnet. Der zweite Teilraum ist in dem montierten Zustand auf einer der Kochfeldplatte 12a abgewandten Seite des Raumteilerelements 18a angeordnet. In dem zweiten Teilraum ist die Steuereinheit 30a angeordnet.

Die Kochfeldvorrichtung 10a weist eine Elektronikeinheit 14a auf (vgl. Fig. 2 bis 6). In einer Einbaulage und in dem montierten Zustand ist die Elektronikeinheit 14a zu einem Großteil innerhalb des von der Außengehäuseeinheit 22a teilweise definierten Lagerraums 24a, und zwar insbesondere in dem zweiten Teilraum, angeordnet.

Die Elektronikeinheit 14a ist von einer Leistungselektronik 32a verschieden. Die Kochfeldvorrichtung 10a weist die Leistungselektronik 32a auf (vgl. Fig. 2). Die Leistungselektronik 32a ist insbesondere in Abhängigkeit einer Ansteuerung durch die Steuereinheit 30a zu einer Versorgung des Heizelements vorgesehen.

In einer Einbaulage ist die Leistungselektronik 32a auf einem Bodengehäuseteil 34a der Außengehäuseeinheit 22a angeordnet. Eine Haupterstreckungsebene der Leistungselektronik 32a ist in einer Einbaulage im Wesentlichen parallel zu einer Haupterstreckungsebene der Kochfeldplatte 12a ausgerichtet.

Die Kochfeldvorrichtung 10a weist eine Lagereinheit 16a auf (vgl. Fig. 2 bis 6). In dem montierten Zustand lagert die Lagereinheit 16a die Elektronikeinheit 14a relativ zu der Kochfeldplatte 12a. Die Lagereinheit 16a lagert die Elektronikeinheit 14a in einer Lage relativ zu der Kochfeldplatte 12a, in welcher eine Haupterstreckungsebene der Elektronikeinheit 14a winklig zu einer Haupterstreckungsebene der Kochfeldplatte 12a ausgerichtet ist. Im vorliegenden Ausführungsbeispiel lagert die Lagereinheit 16a die Elektronikeinheit 14a in einer Lage relativ zu der Kochfeldplatte 12a, in welcher eine Haupterstreckungsebene der Elektronikeinheit 14a im Wesentlichen senkrecht zu einer Haupterstreckungsebene der Kochfeldplatte 12a ausgerichtet ist.

In dem montierten Zustand umgibt die Lagereinheit 16a die Elektronikeinheit 14a in einer Ebene betrachtet bezüglich eines Mittelpunkts und/oder Schwerpunkts der Elektronikeinheit 14a über einen Winkelbereich von im Wesentlichen 360°. Die Ebene, in welcher die Lagereinheit 16a die Elektronikeinheit 14a über den Winkelbereich umgibt, ist in dem montierten Zustand im Wesentlichen parallel zu einer Haupterstreckungsebene der Kochfeldplatte 12a ausgerichtet. Im vorliegenden Ausführungsbeispiel definiert die Lagereinheit 16a einen im Wesentlichen taschenförmigen Aufnahmeraum, in welchem die Elektronikeinheit 14a insbesondere in dem montierten Zustand teilweise angeordnet ist.

Das Raumteilerelement 18a trägt in dem montierten Zustand die Lagereinheit 16a zu einem Großteil. In dem montierten Zustand liegt die Lagereinheit 16a teilweise auf dem Raumteilerelement 18a auf. Die Lagereinheit 16a weist einen Teilbereich auf, welcher in dem montierten Zustand auf dem Raumteilerelement 18a aufliegt.

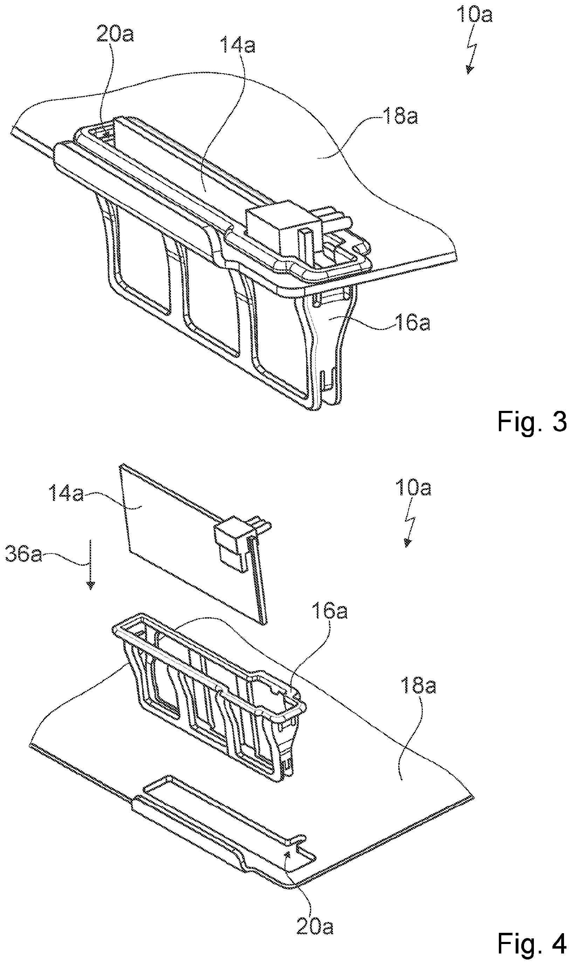

Das Raumteilerelement 18a weist eine Lagerausnehmung 20a auf. Die Lagereinheit 16a greift in dem montierten Zustand teilweise durch eine Lagerausnehmung 20a des Raumteilerelements 18a hindurch. In dem montierten Zustand ist die Lagereinheit 16a in die Lagerausnehmung 20a des Raumteilerelements 18a eingehängt (vgl. auch Fig. 4 bis 6).

In einer Einbaulage und in dem montierten Zustand ist der Teilbereich der Lagereinheit 16a, welcher in dem montierten Zustand auf dem Raumteilerelement 18a aufliegt, oberhalb des Raumteilerelements 18a angeordnet. Ein weiterer Teilbereich der Lagereinheit 16a ist in einer Einbaulage und in dem montierten Zustand unterhalb des Raumteilerelements 18a angeordnet. Der weitere Teilbereich der Lagereinheit 16a ist wesentlich größer als der Teilbereich der Lagereinheit 16a. Die Lagereinheit 16a ist in dem montierten Zustand und in einer Einbaulage zu einem Großteil unterhalb des Raumteilerelements 18a angeordnet.

Die mittels der Lagereinheit 16a gelagerte Elektronikeinheit 14a ist in einer Einbaulage und in dem montierten Zustand zu einem Großteil unterhalb des Raumteilerelements 18a angeordnet. In einer Einbaulage und in dem montierten Zustand ist die Elektronikeinheit 14a teilweise oberhalb des Raumteilerelements 18a angeordnet. Die Elektronikeinheit 14a greift in dem montierten Zustand teilweise durch die Lagerausnehmung 20a des Raumteilerelements 18a hindurch.

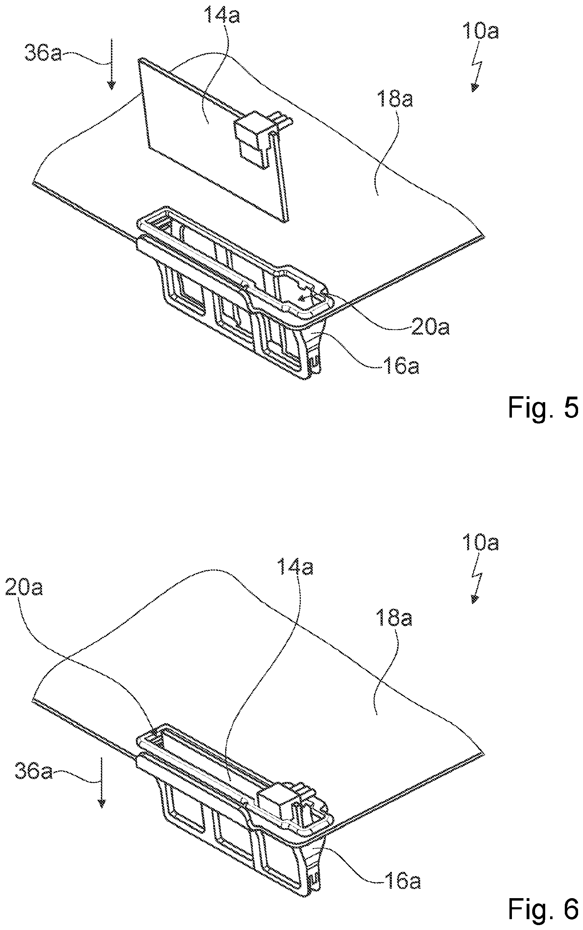

In einem Verfahren zu einer Montage der Kochfeldvorrichtung 10a werden die Lagereinheit 16a und die Elektronikeinheit 14a in einem Bereich der Lagerausnehmung 20a des Raumteilerelements 18a angeordnet (vgl. Fig. 4). Die Lagereinheit 16a wird in einer Montagerichtung 36a in die Lagerausnehmung 20a des Raumteilerelements 18a eingebracht (vgl. Fig. 5). Die Lagereinheit 16a wird in die Lagerausnehmung 20a des Raumteilerelements 18a eingehängt.

Die Elektronikeinheit 14a wird in der Montagerichtung 36a in die in der Lagerausnehmung 20a des Raumteilerelements 18a befindliche Lagereinheit 16a eingebracht (vgl. Fig. 6). In dem Verfahren wird die Elektronikeinheit 14a relativ zu der Kochfeldplatte 12a gelagert. Die Elektronikeinheit 14a wird in einer Lage relativ zu der Kochfeldplatte 12a gelagert, in welcher eine Haupterstreckungsebene der Elektronikeinheit 14a winklig zu einer Haupterstreckungsebene der Kochfeldplatte 12a ausgerichtet ist.

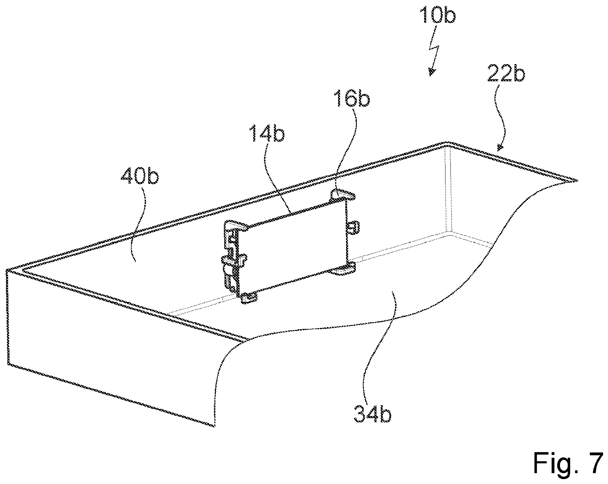

In Fig. 7 bis 9 ist ein nicht erfindungsgemäßes Ausführungsbeispiel gezeigt.

Fig. 7 zeigt einen Ausschnitt einer Außengehäuseeinheit 22b einer nicht erfindungsgemäßen Kochfeldvorrichtung 10b. Die Kochfeldvorrichtung 10b weist eine Lagereinheit 16b auf, welche eine Elektronikeinheit 14b in einem montierten Zustand relativ zu einer Kochfeldplatte 12b lagert.

In dem montierten Zustand umgibt die Lagereinheit 16b die Elektronikeinheit 14b in einer Ebene betrachtet bezüglich eines Mittelpunkts und/oder Schwerpunkts der Elektronikeinheit 14b über einen Winkelbereich von im Wesentlichen 180°. Die Ebene, in welcher die Lagereinheit 16b die Elektronikeinheit 14b über den Winkelbereich umgibt, ist in dem montierten Zustand im Wesentlichen parallel zu einer Haupterstreckungsebene der Kochfeldplatte 12b ausgerichtet.

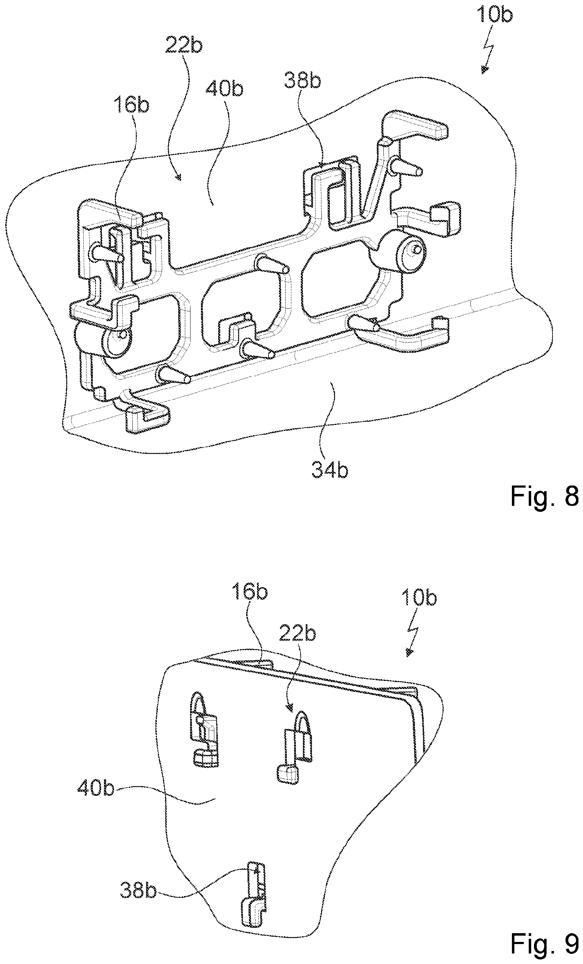

Die Außengehäuseeinheit 22b trägt die Lagereinheit 16b in dem montierten Zustand zu einem Großteil. In dem montierten Zustand ist die Lagereinheit 16b an der Außengehäuseeinheit 22b befestigt. Im vorliegenden Ausführungsbeispiel ist die Lagereinheit 16b an der Außengehäuseeinheit 22b verrastet (vgl. Fig. 8 und 9).

Die Außengehäuseeinheit 22b weist zumindest eine Befestigungsausnehmung 38b auf. Im vorliegenden Ausführungsbeispiel weist die Außengehäuseeinheit 22b drei Befestigungsausnehmungen 38b auf. Alternativ könnte die Außengehäuseeinheit 22b eine andere Anzahl an Befestigungsausnehmungen 38b aufweisen. Im Folgenden wird lediglich eine der Befestigungsausnehmungen 38b beschrieben.

Die Lagereinheit 16b greift in dem montierten Zustand teilweise durch die Befestigungsausnehmung 38b der Außengehäuseeinheit 22b hindurch. Die Befestigungsausnehmung 38b ist in einer Seitenwand 40b der Außengehäuseeinheit 22b angeordnet. In dem montierten Zustand ist die Lagereinheit 16b an der Seitenwand 40b der Außengehäuseeinheit 22b verrastet.

Die Elektronikeinheit 14b ist in dem montierten Zustand zu einem Großteil innerhalb eines von der Außengehäuseeinheit 22b teilweise definierten Lagerraums 24b angeordnet. In dem montierten Zustand ist die Lagereinheit 16b teilweise innerhalb des von der Außengehäuseeinheit 22b teilweise definierten Lagerraums 24b angeordnet.

### Bezugszeichen

- 10: Kochfeldvorrichtung
- 12: Kochfeldplatte
- 14: Elektronikeinheit
- 16: Lagereinheit
- 18: Raumteilerelement
- 20: Lagerausnehmung
- 22: Außengehäuseeinheit
- 24: Lagerraum
- 26: Kochfeld
- 28: Bedienerschnittstelle
- 30: Steuereinheit
- 32: Leistungselektronik
- 34: Bodengehäuseteil
- 36: Montagerichtung
- 38: Befestigungsausnehmung
- 40: Seitenwand

## Patentansprüche

1. Kochfeldvorrichtung, insbesondere Induktionskochfeldvorrichtung, mit zumindest einer Kochfeldplatte (12a-b), mit zumindest einer Elektronikeinheit (14a-b) mit zumindest einer Lagereinheit (16a-b), welche die Elektronikeinheit (14a-b) in wenigstens einem montierten Zustand relativ zu der Kochfeldplatte (12a-b) lagert, wobei die Lagereinheit (16a-b) die Elektronikeinheit (14a-b) in einer Lage relativ zu der Kochfeldplatte (12a-b) lagert, in welcher eine Haupterstreckungsebene der Elektronikeinheit (14a-b) zu einer Haupterstreckungsebene der Kochfeldplatte (12a-b) einen minimalen Winkel von mehr als 0° und weniger als 180° miteinander einschlie-ßen, und mit zumindest einem Raumteilerelement (18a), welches die Lagereinheit (16a) in dem montierten Zustand wenigstens zu einem Großteil trägt, **dadurch gekennzeichnet, dass** die Lagereinheit (16a) in dem montierten Zustand wenigstens teilweise durch eine Lagerausnehmung (20a) des Raumteilerelements (18a) hindurchgreift und wobei die Elektronikeinheit (14a) in dem montierten Zustand teilweise durch die Lagerausnehmung (20a) des Raumteilerelements (18a) hindurchgreift.

2. Kochfeldvorrichtung nach Anspruch 1, **dadurch gekennzeichnet, dass** die Lagereinheit (16a-b) die Elektronikeinheit (14a-b) in dem montierten Zustand in einer Lage relativ zu der Kochfeldplatte (12a-b) lagert, in welcher die Haupterstreckungsebene der Elektronikeinheit (14a-b) wenigstens im Wesentlichen senkrecht zu der Haupterstreckungsebene der Kochfeldplatte (12a-b) ausgerichtet ist.

3. Kochfeldvorrichtung nach einem der vorhergehenden Ansprüche, **dadurch gekennzeichnet, dass** die Lagereinheit (16a-b) die Elektronikeinheit (14a-b) in dem montierten Zustand in zumindest einer Ebene betrachtet bezüglich eines Mittelpunkts und/oder Schwerpunkts der Elektronikeinheit (14a-b) über einen Winkelbereich von mindestens 180° umgibt.

4. Kochfeldvorrichtung nach Anspruch 1, **dadurch gekennzeichnet, dass** die Lagereinheit (16a) in dem montierten Zustand in die Lagerausnehmung (20a) des Raumteilerelements (18a) eingehängt ist.

5. Kochfeldvorrichtung nach einem der vorhergehenden Ansprüche, **dadurch gekennzeichnet, dass** die Lagereinheit (16a) in dem montierten Zustand und in einer Einbaulage wenigstens zu einem Großteil unterhalb des Raumteilerelements (18a) angeordnet ist.

6. Kochfeldvorrichtung nach einem der vorhergehenden Ansprüche, **dadurch gekennzeichnet, dass** die Elektronikeinheit (14a) in dem montierten Zustand und in einer Einbaulage wenigstens teilweise oberhalb des Raumteilerelements (18a) angeordnet ist.

7. Kochfeldvorrichtung nach einem der vorhergehenden Ansprüche, **dadurch gekennzeichnet, dass** die Elektronikeinheit (14a-b) von einer Leistungselektronik (32a-b) verschieden ist.

8. Verfahren zu einer Montage einer Kochfeldvorrichtung (10a-b), insbesondere nach einem der Ansprüche 1 bis 7,
mit zumindest einer Kochfeldplatte (12a-b),
mit zumindest einer Elektronikeinheit (14a-b),
mit zumindest einer Lagereinheit (16a-b), welche die Elektronikeinheit (14a-b) in wenigstens einem montierten Zustand relativ zu der Kochfeldplatte (12a-b) lagert,
wobei die Elektronikeinheit (14a-b) in einer Lage relativ zu der Kochfeldplatte (12ab) gelagert wird, in welcher eine Haupterstreckungsebene der Elektronikeinheit (14a-b) zu einer Haupterstreckungsebene der Kochfeldplatte (12a-b) einen minimalen Winkel von mehr als 0° und weniger als 180° miteinander einschließen,
und mit einem Raumteilerelement (18a), welches die Lagereinheit (16a) in dem montierten Zustand wenigstens zu einem Großteil trägt,
wobei die Lagereinheit (16a) in dem montierten Zustand wenigstens teilweise durch eine Lagerausnehmung (20a) des Raumteilerelements (18a) hindurchgreift, wobei die Elektronikeinheit (14a) in dem montierten Zustand teilweise durch die Lagerausnehmung (20a) des Raumteilerelements (18a) hindurchgreift,
wobei in einem Verfahrensschritt die Lagereinheit (16a) in einer Montagerichtung (36a) in die Lagerausnehmung (20a) des Raumteilerelements (18a) eingebracht wird,
wobei in einem weiteren Verfahrensschritt die Lagereinheit (16a) in die Lagerausnehmung (20a) des Raumteilerelements (18a) eingehängt wird und wobei in einem zusätzlichen weiteren Verfahrensschritt die Elektronikeinheit (14a) in der Montagerichtung (36a) in die in der Lagerausnehmung (20a) des Raumteilerelements (18a) befindliche Lagereinheit (16a) eingebracht wird.

## Claims

1. Hob apparatus, in particular induction hob apparatus, comprising at least one hob plate (12a-b), comprising at least one electronics unit (14a-b), and comprising at least one storage unit (16a-b) which stores the electronics unit (14a-b) in at least one mounted state in relation to the hob plate (12a-b), wherein the storage unit (16a-b) stores the electronics unit (14a-b) in a position in relation to the hob plate (12a-b) in which a main extension plane of the electronics unit (14a-b) and a main extension plane of the hob plate (12a-b) enclose a minimum angle of more than 0° and less than 180° to one another, and comprising at least one space divider element (18a) which in the mounted state stores the storage unit (16a) at least to a large extent, **characterized in that** in the mounted state the storage unit (16a) at least partially engages through a storage recess (20a) of the space divider element (18a) and wherein in the mounted state the electronics unit (14a) partially engages through the storage recess (20a) of the space divider element (18a).

2. Hob apparatus according to claim 1, **characterized in that** in the mounted state the storage unit (16a-b) stores the electronics unit (14a-b) in a position in relation to the hob plate (12a-b) in which the main extension plane of the electronics unit (14a-b) is oriented at least substantially vertically to the main extension plane of the hob plate (12a-b).

3. Hob apparatus according to one of the preceding claims, **characterized in that** in the mounted state the storage unit (16a-b) surrounds the electronics unit (14a-b) over an angular range of at least 180°, when viewed in at least one plane in relation to a central point and/or centre of gravity of the electronics unit (14a-b).

4. Hob apparatus according to claim 1, **characterized in that** in the mounted state the storage unit (16a) is hooked into the storage recess (20a) of the space divider element (18a).

5. Hob apparatus according to one of the preceding claims, **characterized in that** in the mounted state and in an installed position the storage unit (16a) is arranged at least to a large extent below the space divider element (18a).

6. Hob apparatus according to one of the preceding claims, **characterized in that** in the mounted state and in an installed state the electronics unit (14a) is at least partially arranged above the space divider element (18a).

7. Hob apparatus according to one of the preceding claims, **characterized in that** the electronics unit (14a-b) is different from a power electronics unit (32a-b).

8. Method for mounting a hob apparatus (10a-b), in particular according to one of claims 1 to 7,
comprising at least one hob plate (12a-b),
comprising at least one electronics unit (14a-b),
and comprising at least one storage unit (16a-b) which stores the electronics unit (14a-b) in at least one mounted state in relation to the hob plate (12a-b),
wherein the electronics unit (14a-b) is stored in a position in relation to the hob plate (12a-b) in which a main extension plane of the electronics unit (14a-b) and a main extension plane of the hob plate (12a-b) enclose a minimum angle of more than 0° and less than 180° to one another, and comprising a space divider element (18a) which in the mounted state stores the storage unit (16a) at least to a large extent,
wherein in the mounted state the storage unit (16a) at least partially engages through a storage recess (20a) of the space divider element (18a),
wherein in the mounted state the electronics unit (14a) partially engages through the storage recess (20a) of the space divider element (18a),
wherein in a method step the storage unit (16a) is introduced in a mounting direction (36a) into the storage recess (20a) of the space divider element (18a),
wherein in a further method step the storage unit (16a) is hooked into the storage recess (20a) of the space divider element (18a)
and wherein in an additional further method step the electronics unit (14a) is introduced in the mounting direction (36a) into the storage unit (16a) located in the storage recess (20a) of the space divider element (18a).

## Revendications

1. Dispositif de plaque de cuisson, en particulier dispositif de plaque de cuisson à induction, qui comprend au moins une plaque de cuisson (12a-b), au moins une unité électronique (14a-b), au moins une unité de positionnement (16a-b) qui positionne l'unité électronique (14a-b), dans au moins un état monté, par rapport à la plaque de cuisson (12a-b), dans lequel l'unité de positionnement (16a-b) place l'unité électronique (14a-b) dans une position, par rapport à la plaque de cuisson (12a-b), dans laquelle un plan d'extension principal de l'unité électrique (14a-b) par rapport à un plan d'extension principal de la plaque de cuisson (12a-b) forment l'un par rapport à l'autre un angle minimal supérieur à 0° et inférieur à 180°, et au moins un élément de séparation de l'espace (18a) qui supporte l'unité de positionnement (16a), à l'état monté, au moins en grande partie, **caractérisé en ce que** l'unité de positionnement (16a) passe, à l'état monté, au moins en partie, à travers un évidement de positionnement (20a) de l'élément de séparation de l'espace (18a) et dans lequel l'unité électronique (14a) passe, à l'état monté, en partie, à travers l'évidement de positionnement (20a) de l'élément de séparation de l'espace (18a).

2. Dispositif de plaque de cuisson selon la revendication 1, **caractérisé en ce que** l'unité de positionnement (16a-b) place l'unité électronique (14a-b), à l'état monté, dans une position, par rapport à la plaque de cuisson (12a-b), dans laquelle le plan d'extension principal de l'unité électronique (14a-b) est orienté, au moins de manière essentielle, perpendiculairement au plan d'extension principal de la plaque de cuisson (12a-b).

3. Dispositif de plaque de cuisson selon l'une quelconque des revendications précédentes, **caractérisé en ce que** l'unité de positionnement (16a-b) entoure l'unité électronique (14a-b), à l'état monté, dans au moins un plan envisagé par rapport à un point central et/ou un centre de gravité de l'unité électronique (14a-b), sur une plage angulaire d'au moins 180°.

4. Dispositif de plaque de cuisson selon la revendication 1, **caractérisé en ce que** l'unité de positionnement (16a) est suspendue, à l'état monté, dans l'évidement de positionnement (20a) de l'élément de séparation de l'espace (18a).

5. Dispositif de plaque de cuisson selon l'une quelconque des revendications précédentes, **caractérisé en ce que** l'unité de positionnement (16a) est disposée, à l'état monté et dans une position de montage, au moins en grande partie, en dessous de l'élément de séparation de l'espace (18a).

6. Dispositif de plaque de cuisson selon l'une quelconque des revendications précédentes, **caractérisé en ce que** l'unité électronique (14a) est disposée, à l'état monté et dans une position de montage, au moins en partie, au-dessus de l'élément de séparation de l'espace (18a).

7. Dispositif de plaque de cuisson selon l'une quelconque des revendications précédentes, **caractérisé en ce que** l'unité électronique (14a-b) est différente d'une électronique de puissance (32a-b).

8. Procédé destiné à un montage d'un dispositif de plaque de cuisson (10a-b), en particulier selon l'une quelconque des revendications 1 à 7, qui comprend
au moins une plaque de cuisson (12a-b),
au moins une unité électronique (14a-b),
au moins une unité de positionnement (16a-b) qui positionne l'unité électronique (14a-b), dans au moins un état monté, par rapport à la plaque de cuisson (12a-b),
dans lequel on place l'unité électronique (14a-b) dans une position, par rapport à la plaque de cuisson (12a-b), dans laquelle un plan d'extension principal de l'unité électronique (14a-b) par rapport à un plan d'extension principal de la plaque de cuisson (12a-b) forment l'un par rapport à l'autre un angle minimal supérieur à 0° et inférieur à 180°,
et un élément de séparation de l'espace (18a) qui supporte, à l'état monté, au moins en grande partie, l'unité de positionnement (16a),
dans lequel l'unité de positionnement (16a) passe, à l'état monté, au moins en partie, à travers un évidement de positionnement (20a) de l'élément de séparation de l'espace (18a), dans lequel l'unité électronique (14a) passe, à l'état monté, en partie, à travers l'évidement de positionnement (20a) de l'élément de séparation de l'espace (18a),
dans lequel, dans une étape du procédé, on introduit l'unité de positionnement (16a), dans une direction de montage (36a), dans l'évidement de positionnement (20a) de l'élément de séparation de l'espace (18a),
dans lequel, dans une étape ultérieure du procédé, on suspend l'unité de positionnement (16a) dans l'évidement de positionnement (20a) de l'élément de séparation de l'espace (18a),
et dans lequel, dans une étape ultérieure supplémentaire du procédé, on introduit l'unité électronique (14a), dans la direction de montage (36a), dans l'unité de positionnement (16a) qui se trouve dans l'évidement de positionnement (20a) de l'élément de séparation de l'espace (18a).
